# EUROPEAN PATENT SPECIFICATION

(11) **EP 3 875 968 B1**
(45) Date of publication and mention of the grant of the patent: **08.05.2024**
(21) Application number: 21157717.6
(22) Date of filing: 17.02.2021
(51) Int. Cl.: G01R 15/06, G01R 15/16, G01R 29/12

(54) **MULTILAYER ELEMENT FOR ELECTROTECHNICAL APPLICATIONS**
MEHRSCHICHTIGES ELEMENT FÜR ELEKTROTECHNISCHE ANWENDUNGEN
ÉLÉMENT MULTICOUCHE POUR APPLICATIONS ÉLECTROTECHNIQUES

(30) Priority: 17.02.2020 IT 202000003128
(43) Date of publication of application: 08.09.2021
(73) Proprietor: EB Rebosio S.r.l., 25018 Montichiari (BS) (IT)
(72) Inventor: SCARPETTA, Alberto, I-25018 Montichiari, BRESCIA (IT)
(74) Representative: Chimini, Francesco

(56) References cited:
- EP-A2- 3 526 613
- US-A1- 2008 007 889
- US-A1- 2016 139 181
- US-A1- 2017 184 634
- US-A1- 2018 292 435
- US-A1- 2019 234 995
- US-B2- 7 031 135

## Description

The present invention relates to a multilayer element for detecting and/or measuring physical quantities associated with a live electrical conductor, and/or for shielding and/or deflecting the electric field lines generated by the live electrical conductor, where the multilayer element is at least partially embedded or co-molded in a body of insulating material, e.g., an elastomer, a thermoplastic or thermosetting polymer.

It is known to construct electrical shields using micro-stretched or woven nets constituting of a conductive material, for example AISI or brass, flat sheets or with cylindrical-symmetry geometry made of conductive or semi-conductive material, conventionally aluminum alloys, brass, semi-conductive plastics and elastomers.

As for the nets, the tolerance in creating the desired profiles is proportional to the dimensions of the meshes; moreover, the greater the thickness, the less the compatibility of the shield with the overmolding process due to the generation of thermal gradients and expansions.

Nets with traces of lubricant and/or mechanical processing residues generate criticalities in relation to the overmolding process, especially in the case of molding elastomers, thermoplastic and thermosetting polymers. Therefore, cleansing cycles and/or mechanical surface finishing processes, such as for example, surfacing profiles, are required.

The mechanical and electrical performance is dependent on the variation of alloy or production process used.

In the case of micro-stretched nets, there is the risk of the formation of tips in the cutting sections; therefore, there is a need to use mechanical contrivances such as rounding or joining in order to reduce the parasitic effects resulting from the charge concentration.

In the case of a woven net, inelastic deformations can occur both during the overmolding processing and during the handling operation, in particular if the net is used in complex architectures.

The sheet or ring made of conductive or semi-conductive material has a dimensional variability which is inversely proportional to the thickness selected: the greater the thickness, the greater the incompatibility to the overmolding process due to the generation of thermal gradient and the different thermal expansion coefficients.

Thermal gradients, coupling of materials characterized by different thermal expansion coefficients, presence of lubricants and mechanical processing residues, significant surface discontinuities, can be the cause of detachments, cracks, air bubbles, impurities in the insulating material and on the contact surface between insulating material and co-molded architecture, with consequent concentration of charge and electrical stress, therefore the worsening of the performance of the item in operating conditions from a production, electrical, early ageing viewpoint. Prior art HV sensors are known from US2018/292435, US2017/184634, US7031135, US2008/007889, and US2016/139181.

It is the object of the present invention to suggest a multilayer element capable of overcoming, or in any case significantly reducing, the above drawbacks.

Such an object is achieved by a method according to claim 1, and a device according to claim 9.

The dependent claims describe preferred or advantageous embodiments of the invention.

The features and advantages of the multilayer element according to the invention will in any case become apparent from the following description of preferred embodiments thereof, given only by way of nonlimiting, indicative example, with reference to the accompanying drawings, in which:
- Figure 1 is a perspective view of a multilayer element according to the invention, in an embodiment;
- Figure 1a is a longitudinal section of the multilayer element in Figure 1;
- Figure 1b shows the multilayer element according to the invention, placed around an electrical conductor acting as a source electrode of electric field;
- Figure 1c shows the multilayer element according to the invention, placed around an electrical conductor acting both as a source electrode of electric field and as possible sources of interfering electric field placed externally thereto;
- Figures 2-2c are perspective, plan and top views, respectively, of a multilayer element according to the invention, in an embodiment with a screw or mechanical fastening pin thereof with possible extraction function of the signal of interest;
- Figures 3 and 3a are two plan views (top and bottom) of a multilayer element according to the invention, in another embodiment;
- Figure 4 depicts a device for electrotechnical applications when inserting an electrical conductor acting as source of electric field, and which incorporates the multilayer element in Figures 2 and 3 in radial position with respect to the electrical conductor;
- Figures 5 and 5a are a perspective view and an axial section of a multilayer element according to the invention, in another embodiment;
- Figures 6-6b show the multilayer element in Figures 5 and 5a embedded in a device for electrotechnical applications which incorporates an electrical conductor acting as source electrode of electric field.

Examples of multilayer elements according to the invention, for manufacturing electronic circuits on a sublayer made of electrically insulating material, in single or multilayer configuration, are described herein. Such multilayer elements are intended to be embedded in insulating materials, such as thermoplastic, thermosetting polymers and elastomers, such as (not limited to) epoxy resin, LSR, SSR, HCR, EPDM, XLPE, PSU, PEEK, for electrotechnical applications in the medium- and high-voltage domain, independently of the operation frequency, and/or for RF and high frequency commutation and communication systems.

The expression "multilayer element" in the context of the present disclosure therefore means an element which comprises at least one insulating substrate and at least one conductive layer coupled to a side of the insulating substrate.

In particular, the insulating substrate is made from a mineral fiber mesh, e.g., glass fiber, embedded in a matrix of insulating material, preferably epoxy-based. An example of such an insulating substrate is commercially known as FR4, where the abbreviation "FR" is for "flame retardant".

In the continuation of the description, reference is made to the following abbreviations:
FR4: is only the insulating substrate;
FR4SF: is the insulating substrate integral with a conductive layer;
FR4DF: is the insulating substrate integral with two conductive layers;
multilayer FR4: is a sandwich of a number N of insulating layers alternating with a number N+1 of conductive layers.

The multilayer elements suggested herein are made, for example, in order to:
- condition signals acquired by transducers with functions of:
   - voltage presence;
   - magnetic field and/or electric field and respective phase angle analysis;
   - presence and/or distribution feature of partial discharges;
   - temperature/gas/environmental analysis;
- implement the following systems:
   - PWM self-powering and commutation;
   - storing, analyzing, and managing acquired signals;
   - wireless communication;
   - PLC modulation and communication;
   - data sharing;
   - product traceability/identification.

The multilayer elements of the present disclosure allow to obtain multilayer arrangements with one or more functions on a single planar development, i.e., on a single conductive layer.

For example, by using an FR4 multilayer, the overall thickness can be restrained to 0.1-0.4 mm, preferably 0.2 mm.

With such thicknesses, the planar development would be flexible and pre-formable, without compromising the mechanical and electrical properties, thus obtaining solutions which is adaptable to the geometry of the item in which the multilayer element is embedded.

The multilayer elements of the present disclosure are compatible with processes of:
- thermoforming, in order to obtain the following profiles:
   - lamellar, for creating capacitive couplings or differential transducers;
   - wavy, for obtaining an increased coupling area in small spaces;
   - frustoconical, for creating electric field deflectors;
- electrowelding, so as to obtain cylindrical geometries for planar development;
- COB, for a miniaturization of the circuit transfer functions;
- photoengraving;
- mechanical removal;
- cutting/shearing.

In certain embodiments, masks are formed, on the same layer, or on two opposing conductive layers of the same insulating layer, by means of conductive areas in order to shield, dissipate, deflect and/or guide interfering electric field lines with respect to other conductive areas exposed to the field lines generated by further sources of electric field.

"Interfering electric fields" means electric fields generated by other sources of electric field, different from the electrical conductor to which the multilayer element is intended to be applied.

In certain embodiments, transducers, filters, active and/or passive components, e.g., RFID antennas, can be located on a conductive layer.

In certain embodiments, the multilayer element is crossed by one or more metallized holes suitable to extract the signals obtained, for example by capacitive coupling, from the critical area between the conductive layer and a source of electric field placed under conditions of medium- or high-voltage, without altering the distribution of the field lines, and therefore without penalizing the electric stress which is typical of the area.

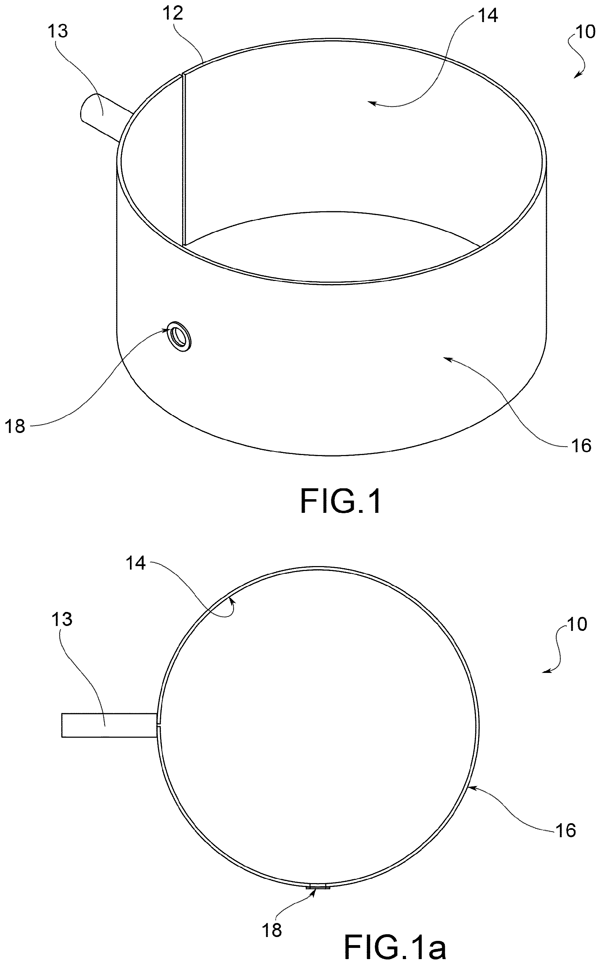

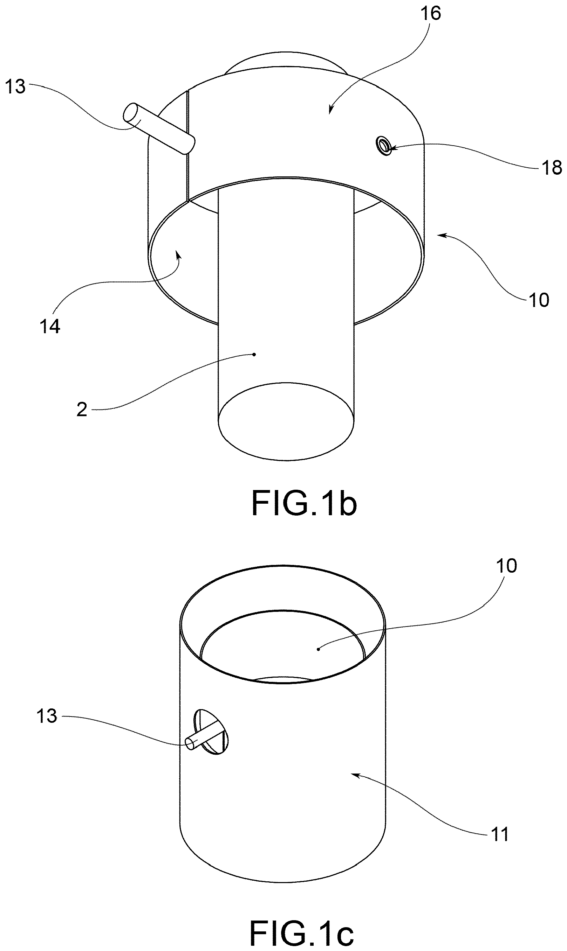

In an embodiment shown in Figures 1-1c, the multilayer element 10 has a cylindrical shape and therefore is configured to be positioned around a source electrode 2, generator of electric field.

The multilayer element 10 comprises an insulating substrate 12, for example made of FR4, a first electrically conductive layer 14 coupled to the inner side of the insulating substrate, i.e., the side facing the source electrode, so as to be exposed to the electric field lines generated by the source electrode, and a second electrically conductive layer 16 coupled to the outer side of the insulating substrate 12.

The first layer 14 performs the function of capacitive coupling; the second layer 16, when referred to a zero potential or to ground, performs the function of shielding element.

The multilayer element 10 is crossed by a metallized hole 18 which ensures the electric continuity between the first layer 14 and the second layer 16 and allows the electrowelding of metal inserts.

In an embodiment, the two conductive surfaces 14 and 16 are coupled to the insulating substrate 12 through a rolling process.

The cylindrical shape of the multilayer element can be obtained from a planar development of the multilayer element.

In the embodiment in Figure 1c, the multilayer element 10 is inserted coaxially into a cylindrical electrical conductor 11, serving both a function of source electrode of electric field and shield with respect to possible sources of interfering electric field placed externally thereto. The multilayer element 10 is provided with a metal pin 13 or a screw which extends, e.g., radially, from the second layer 16, having the function of mechanical connection to a support structure and/or of electric connection if a single contact pin is sufficient, for example to detect the presence of voltage on the source electrode 2, extracting an alternating voltage VAC which is proportional to the voltage of the source electrode. For example, the metal pin is brought to the alternating voltage VAC obtained by capacitive coupling and can be connected to a warning light system.

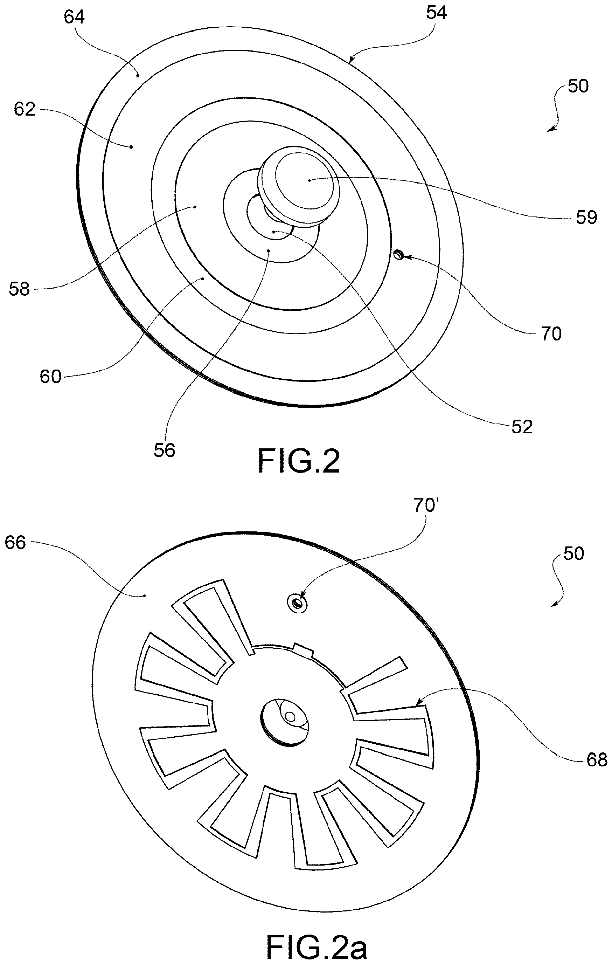

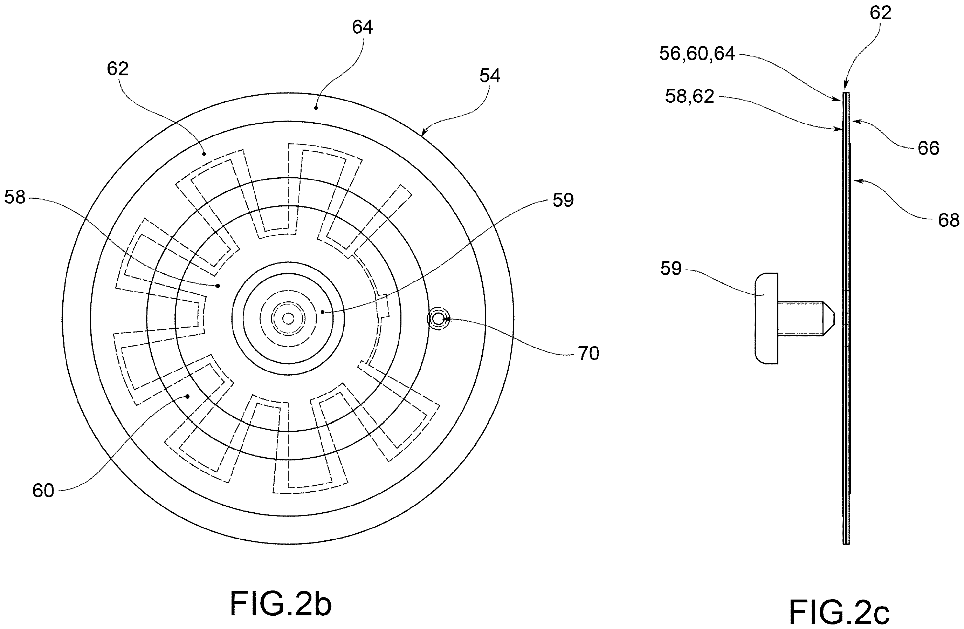

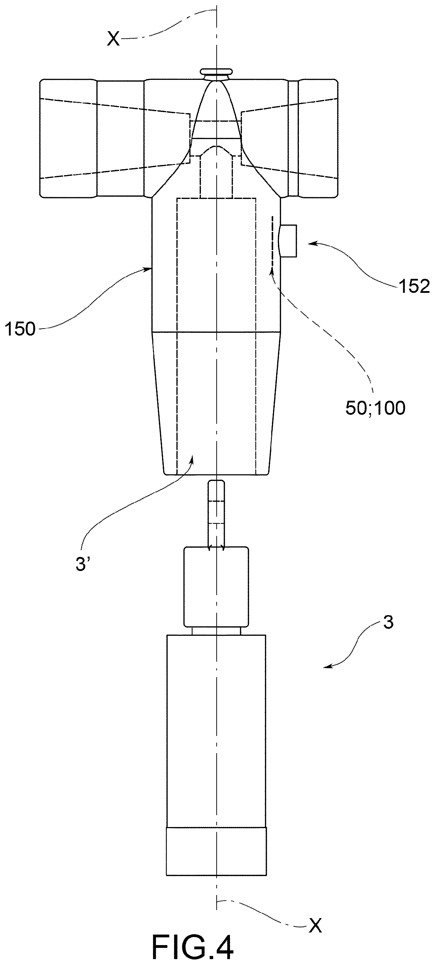

In an embodiment shown in Figures 2-2c, the multilayer element 50 has a planar structure, for example circular in shape. In this embodiment, the multilayer element 50 is suitable to be positioned radially, i.e., sideways, with respect to a source electrode 3 which generates the electric field (shown, for example in Figure 4).

In an embodiment, the multilayer element 50 is crossed by a central opening 52 for a mechanical fastening thereof to a support, for example by means of a screw 59.

The multilayer element 50 comprises an insulating substrate 54, for example which extends for the whole area of the multilayer element.

The multilayer element 50 comprises, on the side facing the source electrode, a radial alternation of conductive and insulating layers, for example which are coaxial to one another.

In the example shown, there are obtained, on the side facing the source electrode, or front/upper side, starting from the central opening 52, a first insulating circular crown 56, for example made of FR4, having the function of separation between the central opening 52 and a second conductive circular crown 58, which forms a first conductive layer having function of capacitive coupling with respect to the electrode, and of electric field shield in favor of a conductive layer opposing the insulating substrate, which is in the shadow zone with respect to the electric field lines generated by the source electrode. A third insulating circular crown 60, for example made of FR4, is formed around this second conductive circular crown 58, which third insulating circular crown electrically separates, i.e., decouples, the second conductive circular crown 58 from a fourth conductive circular crown 62, which makes a second conductive layer having a function both of capacitive coupling with respect to the source electrode and of deflector of electric field and/or of electric shield. Being the outermost conductive crown, the function of field deflector optimizes the immunity of the innermost conductive crowns with respect to interfering, deflected field lines. As described above, the function of shield is in favor of the conductive layer opposing the insulating substrate. A fifth insulating circular crown 64, for example made of FR4, is obtained around the fourth conductive circular crown 62.

In an embodiment, the insulating circular crowns are obtained by removal of a conductive layer coupled to the insulating substrate 54; the remainder of the conductive layer after such a removal therefore forms the conductive circular crowns.

The radially innermost (56) and outermost (64) insulating circular crowns also have a function of reducing the peripheral electric stresses.

The side of the multilayer element 50 opposite to the source electrode can be an insulating layer 66, for example the side of the insulating substrate 54 opposite to the one on which the conductive layers are coupled. In other words, the insulating layer 66 constitutes of the back/lower side of the same insulating substrate 54.

A third lower or back conductive layer 68 is formed on this insulating layer, which creates a circuitry and/or an RFID antenna and/or a COB IC and/or pads and tracks for SMD components.

Moreover, the multilayer element 50 is crossed by a metallized hole 70 which ensures an electric continuity between the conductive circular crown 62 formed on the upper/front layer and the lower/back conductive layer. For example, such a metallized hole 70 on the back/lower side is provided with an annular pad 70' for welding a signal wire for drawing the signal obtained from capacitive coupling without compromising the electric performance in the area between electrode and capacitive coupling, which is considered critical.

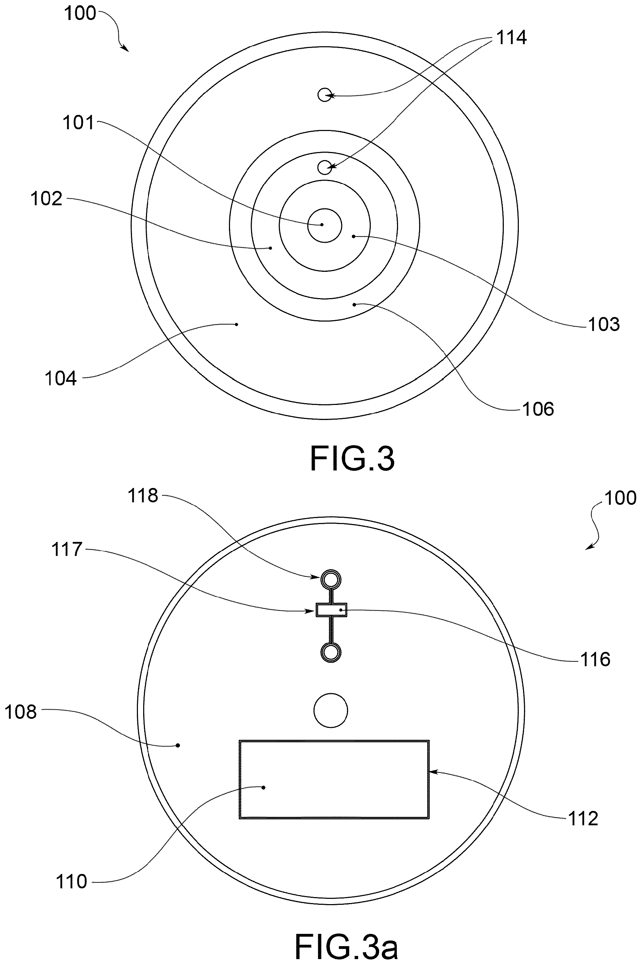

In the embodiment shown in Figures 3 and 3a, the multilayer element 100 has the same planar structure as the multilayer element 50 in Figures 2-2c and has a front, or upper side, i.e., facing the source electrode of electric field 3, with a similar radial alternation of annular conductive layers and of annular insulating layers, which are coaxial to a central through opening 101 which is suitable for the mechanical fastening to a support structure.

A first conductive layer 102 having for example a function of measuring the electric field through capacitive coupling is obtained around a first annular insulating layer 103 which surrounds the central opening 101.

A second annular conductive layer 104, which is outermost and separated from the first by an insulating layer 106, can have the function of voltage detection, for example.

The back, or lower, side of the multilayer element 100 forms a third conductive layer 108, for example with function of planar electric shield when referred to zero potential or to ground.

Again, a fourth conductive layer 110 is formed on the back side of the multilayer element 100, which fourth conductive layer is separated from the third conductive layer 108 by a peripheral insulating layer, or clearance, 112. This fourth conductive layer 110 can, for example have the function of RFID antenna or of other circuit elements, similarly to the conductive layer 68 of the embodiment in Figures 2-2c.

Moreover, the multilayer element 100 is crossed by one or more metallized holes 114 for extracting signals of interest from the electrically critical area, i.e., the area between the source electrode and the front/upper side of the multilayer element, when operating in medium- and high-voltage, and without compromising the electric performance of the system. Indeed, the signals are brought back to welding pads on the back/lower layer, i.e. the one opposite to the critical area, under shielding condition provided either by an interposed conductive layer, referred to zero potential or ground potential, in the case of insulating substrate in multilayer configuration (i.e. constituting of a sandwich of insulating layers alternating with conductive layers), or by the same conductive layer which also serves the function of capacitive coupling on the front/upper layer, if the sizes are suitable for ensuring an adequate shadow zone.

On the back or lower side, the metallized holes 114, for example electrically connected to a suitable footprint 116 for welding an SMD output connector, are obtained in a fifth conductive layer 117 which can provide the weldability of a circuitry, pad and strip, for example with functions of conditioning and managing acquired signals, self-powering systems, snubber protection networks.

This fifth conductive layer 117 is separated from the third conductive layer 108 by means of a peripheral insulating layer, or clearance, 118.

In addition to serving the function of planar and peripheral electric decoupling between conductive layers, it should be noted that the insulating layer 103 around the central opening 52; 101 forms an insulated supporting surface for the head of the fastening screw 59. If instead the fastening screw 59 also serves the function of connector for extracting one of the acquired signals, the head is to rest on the conductive layer of interest.

Figure 4 diagrammatically shows the planar multilayer element 50; 100 embedded in a body 150 made of insulating material and in which a conductor, source of electric field 3, is inserted. Figure 4 shows conductor 3 prior to the insertion thereof into a respective seat 3' obtained in body 150.

In the example shown, body 150 is a "T" connector made of an elastomer, e.g., EPDM or LSR. The source electrode 3 constitutes of an MV (medium-voltage) wire ending with a lug to be crimped, which during the installation thereof is inserted and mechanically fastened in the T connector 150.

The planar multilayer element 50; 100 is positioned radially to the source 3 of electric field. In other words, source 3 mainly extends along a source axis X, and the multilayer element 50; 100 lies on a plane which is parallel to the source axis X.

As described above, in an embodiment, the multilayer element 50; 100 is held in position by mechanical screw or connector fastening. The example in Figure 4 shows a connector 152 which is complementary to the SMD connector integral with the multilayer element 50; 100 due to the transmission of the acquired signals to a remote device, or in the shape of complementary insert to screw 59 used for the mechanical fastening, if one signal transmission pin alone is of interest.

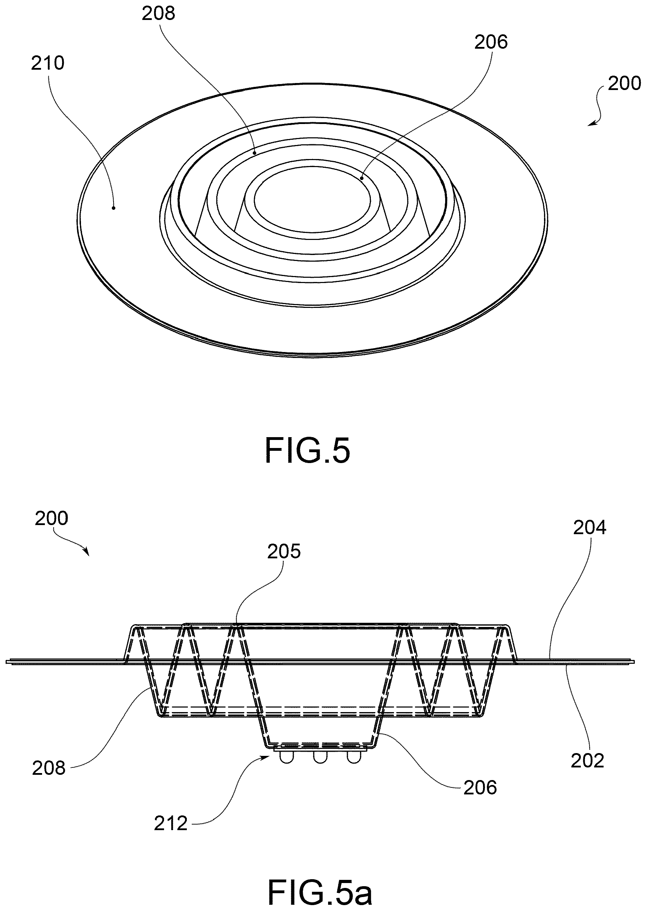

In the embodiment shown in Figures 5 and 5a, the multilayer element 200 has a wavy structure, obtained for example by thermoforming.

The multilayer element 200 has an insulating substrate, 202, for example a Vetronite FR4 plate, on which front or upper side suitable to face a source electrode 230 a first conductive layer 205, for example with function of analyzing the voltage on the source electrode 230, and a second conductive layer 204, for example with function of detecting voltage on the source electrode 230, are coupled.

The insulating substrate 202 serves a support function for the two conductive layers.

The multilayer element has a frustoconical central portion 206, from which end a series of wavy portions 208 coaxial to the central portion 206 radially extend.

In an embodiment, the first conductive layer 205 is integral with and extends over the central portion 206 and over the wavy portions 208.

An annular flat portion 210 can extend from the outermost wavy portion. The second conductive layer 204 is integral with and extends over the flat portion 210, minus a peripheral clearance area required to reduce the peripheral electrical gradient.

Thereby, an increase of the surface exposed to the field lines of an electric field generated by a source electrode 230 placed in front of and aligned with the central portion 206, is obtained. Therefore, the signal detected by capacitive coupling in a small space, which would not be sufficient if it were detected linearly, can be increased.

The back or lower side of the frustoconical central portion 206 can be provided with a conductive layer which is suitable for networks for conditioning the acquired signals, to communication systems such as RFID antennas, COB IC, welding components and active and passive transducers, to the footprint for welding a multipolar SMD connector 212 for the mechanical support of the multilayer element 200 during the co-molding operation and for transmitting the acquired signals to remote devices (if the multilayer element 200 has no through hole for a fastening screw). For example, the multipolar connector 212 is fastened by welding on a conductive pad obtained on the back side of the central portion 206.

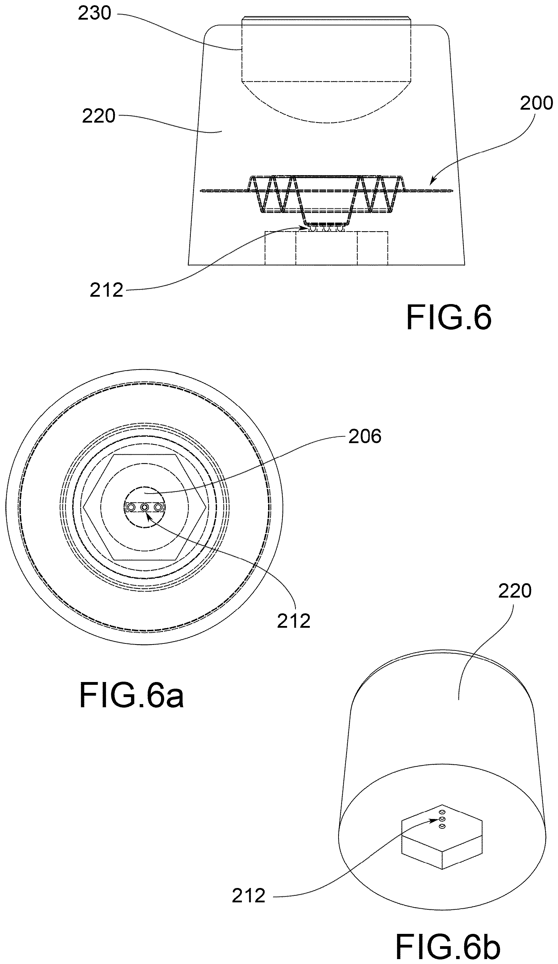

Figures 6-6b show the multilayer element 200 embedded in a body 220 made of an insulating material and in which a source electrode 230 is at least partially embedded.

Those skilled in the art will appreciate that the embodiments described for the multilayer elements with planar or wavy structure can possibly be applied, with suitable adaptations, to the multilayer elements with cylindrical or frustoconical structure.

According to an aspect of the invention, the insulating substrate of the multilayer element is made from a mineral fiber mesh, e.g., glass fiber, embedded in a matrix of insulating material, preferably epoxy-based.

In certain embodiments, several conductive portions electrically decoupled from one another so as to obtain different functions such as RFID antennas, pads and strips suitable to create any type of circuitry, shields and deflectors, capacitive couplings with different conversion ratios, are obtained in the same conductive layer, for example by photoengraving.

Thereby, different functions and/or capacitive couplings suitable to provide a signal which is linearly proportional to the voltage value of the electrical conductor can be obtained on the same conductive layer.

In an embodiment, each conductive layer is made of copper.

In an embodiment, the multilayer element has a shape obtained by a thermoforming and/or electrowelding and/or photoengraving process.

In an embodiment, the multilayer element further has a shape with no sharp edges so as to reduce the formation of electric stress.

In certain embodiments, the multilayer element has a cylindrical or substantially frustoconical shape. The cylindrical shape allows to maximize the shielding from interfering electric fields. The frustoconical shape allows to obtain a highly accentuated deflection of the electric field lines.

In an embodiment, each insulating layer needs to ensure a flexibility of the assembly which, with the conductive components, reaches a recommended thickness of 0.2 mm.

The present invention further relates to a device for electrotechnical applications in the medium- and high-voltage domain, comprising a device body made of an electrically insulating material, at least one electrical conductor at least partially embedded in the device body, and a multilayer element as described above, embedded in the device body in front of, or parallel to, or around the electrical conductor.

In an embodiment, the device is provided with an electrical connector partially embedded in the body made of insulating material for the electrical connection to the multilayer element.

The present invention further relates to a method for measuring, shielding and/or deflecting the field lines of an electric field generated by an electrical conductor at least partially embedded in a device body made of insulating material. In a general embodiment, the method comprises the steps of:
- providing a multilayer element as described above;
- giving the multilayer element a planar shape, with circular or cylindrical symmetry;
- positioning the electrical conductor and the multilayer element in a cavity of a mold for the construction of the device body, the laminated multilayer element being placed parallel or coaxially to the electrical conductor;
- co-molding the electrical conductor and the multilayer element with the insulating material.

In an embodiment, the multilayer element undergoes a thermoforming and/or electrowelding and/or photoengraving process before it is placed in the mold.

In an embodiment, the insulating substrate undergoes a surface finishing process, for example by means of placement of a layer of silver or chemical gold or tin, before it is placed in the mold.

The use of an insulating layer made from a mineral fiber mesh, e.g., glass fiber, embedded in a matrix of insulating material, preferably epoxy-based, and in particular the use of Vetronite (FR4) allow to achieve a multiplicity of advantages.

Not only can a conductive layer be coupled to an insulating layer, but multilayer laminates with an alternation of conductive and insulating layers (FR4 multilayer) can be obtained.

The variability of the raw material is negligible with respect to the overmolding process.

Increased dimensional stability in the case of mechanical, thermal, and electrical stresses.

The thermal expansion coefficient of the Vetronite optimizes the adhesion between the shielding element and the insulating material in which it is embedded.

Little degradation over time due to the thermal effect.

Absence of carbonization ensuring a structural invariance and consequent absence of early ageing under operating conditions.

Increased control and repeatability of the production process, related to the raw material and the processing thereof.

Processing tolerance in the order of the µm.

Absence of parasitic, intrinsic and/or surface electrical phenomena.

Absence of processing residues.

Absence of significant surface and periphery discontinuities for the overmolding process.

Null water absorption.

Compatibility with thermoforming, electrowelding, COB, photoengraving, mechanical processing processes.

Therefore, it is a material which is particularly suitable to obtain electric field shielding and deflecting systems, RFID communication, and consequent self-powering systems, single or multiple capacitive coupling, also with different performance, functions, conversion ratios on a single planar development.

The result is a significant structural simplification of the shielding structure.

The electrical insulation is ensured both between coplanar couplings and between parallel layers.

The planar development is flexible and/or pre-formable, without compromising the mechanical and electrical properties, thus obtaining solutions which are useful both for planar and cylindrical-symmetry applications.

The use of insulating layers of FR4 with thickness of about 0.2 mm allows to obtain:
- flexibility and moldability and does not create cracks during the shrinkage of the co-molded materials, such as epoxy resin, thermosetting and thermoplastic polymers and elastomers;
- negligible thermal gradients with respect to the overmolding process;
- negligible peripheral electrical stress under operating condition in the medium- and high-voltage domain.

Overall surface and volume size reduced as compared to the prior art.

Absence of meshes and spacers between layers.

The optimization of the processing tolerances as compared to the prior art allows:
- a low production variability with respect to an initial prototype/sample;
- the achievement of accuracy classes in creating superior capacitive couplings;
- complex cabling and/or facilitated circuitry compensations. Analogy with printed circuit.

The surface finish with silver, chemical gold, or tin:
- preserves the conductive layers from oxidization, damage and early ageing during storage, handling, operation;
- allows to optimize the surface distribution of the temperature.

The multilayer structure gives the possibility of shielding/dissipating the interfering electric field by optimizing the immunity of the capacitive coupling created on a parallel second layer.

It should be noted that the multilayer element according to the invention allows the sensors and/or transducers which are integral with the multilayer support, e.g., Hall effect sensors, temperature sensors, capacitive couplings, to be moved as close as possible to the source electrode, which thus benefit from increased accuracy. Indeed, the closer the source is and the more near-field conditions occur, the less the presence of interferences and damping phenomena of the monitored source is.

In order to meet contingent needs, those skilled in the art may make changes and adaptations to the embodiments of the invention or can replace elements with others which are functionally equivalent without departing from the scope of the following claims. Each of the features described as belonging to a possible embodiment can be achieved irrespective of the other embodiments described.

## Claims

1. Method for detecting and/or measuring physical quantities associated with a live electrical conductor (2) at least partially embedded or inserted in a device body made of insulating material, comprising the steps of:
- providing a multilayer element (10);
- giving the multilayer element a cylindrical or frustoconical shape;
wherein the multilayer element comprises at least one insulating substrate (12) made from a mineral fiber mesh, for example glass fiber, embedded in a matrix of insulating material, preferably epoxy-based, and a plurality of conductive layers (14, 16) coupled to said at least one insulating substrate and comprising sensors and/or transducers and/or circuit networks to perform one or more functions including detection, measurement, protection, commutation, modulation, management and/or communication of acquired signals, said conductive layers being coupled on one or both sides of the insulating substrate, the conductive layers coupled on the same side of the insulating substrate being electrically separated from each other, wherein at least one conductive layer (16) has a function of shielding and/or deflecting the field lines of the electric field generated by the live conductor, and wherein the insulating substrate also has a function of mechanical support for the multilayer element,
**characterized in**:
positioning the electrical conductor and the multilayer element in a cavity of a mold for the construction of the device body, the multilayer element being placed coaxially to the electrical conductor; - co-molding the electrical conductor and the multilayer element with the insulating material.

2. Method according to claim 1, wherein the multilayer element comprises a plurality of conductive layers coupled to one or both sides of an insulating substrate, the conductive layers coupled on the same side of the insulating substrate being electrically separated from each other.

3. Method according to any one of the preceding claims, wherein the multilayer element comprises at least two conductive layers coupled on opposite sides of the insulating substrate, the multilayer element being penetrated by at least one metallized hole suitable for electrically connecting conductive layers coupled on opposite sides of the insulating substrate.

4. Method according to any one of the preceding claims, wherein in at least one of the conductive layers there are obtained by photoengraving several conductive portions electrically decoupled from each other in order to obtain capacitive couplings with different conversion ratios.

5. Method according to any one of the preceding claims, wherein one or more conductive layers form an RFID antenna.

6. Method according to any one of the preceding claims, wherein each insulating layer is made of a glass fiber fabric interwoven into an epoxy resin matrix, preferably flame retardant and self-extinguishing.

7. Method according to any one of the preceding claims, wherein the shape of the multilayer element is obtained by a thermoforming and/or electrowelding and/or photoengraving process.

8. Method according to any one of the preceding claims, wherein the multilayer element has a thickness of about 0.2 mm, where each conductive layer has a thickness of about 35 µm.

9. Device for electrotechnical applications in the medium- and high-voltage domain, comprising a device body made of an electrically insulating material, at least one electrical conductor (2) at least partially embedded or inserted in the device body, and a multilayer element (10) embedded in the device body around the electrical conductor,
wherein the multilayer element has a cylindrical or frustoconical shape so as to be positioned around the electrical conductor and comprises at least one insulating substrate (12) made from a mineral fiber mesh, for example glass fiber, embedded in a matrix of insulating material, preferably epoxy-based, and a plurality of conductive layers (14, 16) coupled to said at least one insulating substrate and comprising sensors and/or transducers and/or circuit networks to perform one or more functions including detection, measurement, protection, commutation, modulation, management and/or communication of acquired signals, said conductive layers being coupled on one or both sides of the insulating substrate, the conductive layers coupled on the same side of the insulating substrate being electrically separated from each other, wherein at least one conductive layer (16) has a function of shielding and/or deflecting the field lines of the electric field generated by the live conductor, and wherein the insulating substrate also has a function of mechanical support for the multilayer element,
**characterized in that**
the electrical conductor and the multilayer element are co-molded with the electrically insulating material of the device body.

10. Device according to the preceding claim, comprising an electrical connector partially embedded in the body made of insulating material for the electrical connection to the multilayer element.

11. Device according to claim 9 or 10, wherein the electrically insulating material is selected from among epoxy resin, LSR, SSR, HCR, EPDM, XLPE, PSU, PEEK.

12. Method according to any of the claims 1-8, wherein the multilayer element undergoes a thermoforming and/or electrowelding and/or photoengraving process before it is placed in the mold.

## Patentansprüche

1. Mehrschichtiges Element zum Detektieren und/oder Messen physikalischer Größen, die einem stromführenden elektrischen Leiter (2) zugeordnet sind, der zumindest teilweise in einem Vorrichtungskörper aus isolierendem Material eingebettet oder eingeführt ist, umfassend die Schritte:
- Bereitstellen eines mehrschichtigen Elements (10);
- Verleihen einer zylindrischen oder kegelstumpfförmigen Form an das mehrschichtige Element;
wobei das mehrschichtige Element zumindest ein isolierendes Substrat (12) aus einem Mineralfasergewebe, zum Beispiel Glasfaser, eingebettet in eine Matrix aus isolierendem Material, bevorzugt auf Epoxidbasis, und eine Vielzahl von leitfähigen Schichten (14, 16) aufweist, die mit dem zumindest einen isolierenden Substrat gekoppelt sind und Sensoren und/oder Wandler und/oder Schaltkreisnetzwerke aufweisen, um eine oder mehrere Funktionen auszuführen, welche Detektion, Messung, Schutz, Kommutierung, Modulation, Verwaltung und/oder Kommunikation erfasster Signale umfassen, wobei die leitfähigen Schichten auf einer oder beiden Seiten des isolierenden Substrats gekoppelt sind, wobei die leitfähigen Schichten, die auf derselben Seite des isolierenden Substrats gekoppelt sind, elektrisch voneinander getrennt sind, wobei zumindest eine leitfähige Schicht (16) die Funktion hat, die Feldlinien des von dem stromführenden Leiter erzeugten elektrischen Feldes abzuschirmen und/oder abzulenken, und wobei das isolierende Substrat ebenfalls die Funktion hat, das mehrschichtige Element mechanisch zu stützen,
**gekennzeichnet durch**:
- Positionieren des elektrischen Leiters und des mehrschichtigen Elements in einem Hohlraum einer Form für die Konstruktion des Vorrichtungskörpers, wobei das mehrschichtige Element koaxial zu dem elektrischen Leiter platziert wird;
- gemeinsames Formen des elektrischen Leiters und des mehrschichtigen Elements mit dem isolierenden Material.

2. Verfahren nach Anspruch 1, wobei das mehrschichtige Element eine Vielzahl von leitfähigen Schichten aufweist, die mit einer oder beiden Seiten eines isolierenden Substrats gekoppelt sind, wobei die leitfähigen Schichten, die auf derselben Seite des isolierenden Substrats gekoppelt sind, elektrisch voneinander getrennt sind.

3. Verfahren nach einem der vorstehenden Ansprüche, wobei das mehrschichtige Element zumindest zwei leitfähige Schichten aufweist, die auf gegenüberliegenden Seiten des isolierenden Substrats gekoppelt sind, wobei das mehrschichtige Element von zumindest einem metallisierten Loch durchdrungen ist, das zum elektrischen Verbinden von leitfähigen Schichten geeignet ist, die auf gegenüberliegenden Seiten des isolierenden Substrats gekoppelt sind.

4. Verfahren nach einem der vorstehenden Ansprüche, wobei in zumindest einer der leitfähigen Schichten durch Fotogravur mehrere elektrisch voneinander entkoppelte, leitfähige Abschnitte erhalten werden, um kapazitive Kopplungen mit unterschiedlichen Wandlungsverhältnissen zu erhalten.

5. Verfahren nach einem der vorstehenden Ansprüche, wobei eine oder mehrere leitfähige Schichten eine RFID-Antenne bilden.

6. Verfahren nach einem der vorstehenden Ansprüche, wobei jede isolierende Schicht aus einem in eine Epoxidharzmatrix eingewebten Glasfasergewebe, bevorzugt flammhemmend und selbstverlöschend, hergestellt ist.

7. Verfahren nach einem der vorstehenden Ansprüche, wobei die Form des mehrschichtigen Elements durch einen Thermoform- und/oder Elektroschweiß- und/oder Fotogravur-Prozess erhalten wird.

8. Verfahren nach einem der vorstehenden Ansprüche, wobei das mehrschichtige Element eine Dicke von etwa 0,2 mm aufweist, wobei jede leitfähige Schicht eine Dicke von etwa 35 µm aufweist.

9. Vorrichtung für elektrotechnische Anwendungen im Mittel- und Hochspannungsbereich, aufweisend einen Vorrichtungskörper aus einem elektrisch isolierenden Material, zumindest einen in den Vorrichtungskörper zumindest teilweise eingebetteten oder eingeführten elektrischen Leiter (2), und ein mehrschichtiges Element (10), das in den Vorrichtungskörper um den elektrischen Leiter herum eingebettet ist,
wobei das mehrschichtige Elemente eine zylindrische oder kegelstumpfförmige Form hat, so dass es um den elektrischen Leiter herum positioniert ist, und zumindest ein isolierendes Substrat (12) aufweist, das aus Mineralfasergewebe, zum Beispiel Glasfaser, eingebettet in einer Matrix aus isolierendem Material, bevorzugt auf Epoxid-Basis, sowie eine Vielzahl von leitfähigen Schichten (14, 16) aufweist, die mit dem zumindest einen isolierenden Substrat gekoppelt sind und Sensoren und/oder Wandler und/oder Schaltungsnetzwerke aufweisen, um eine oder mehrere Funktion umfassend Detektion, Messung, Schutz, Kommutierung, Modulation, Verwaltung und/oder Kommunikation von erfassten Signalen durchzuführen, wobei die leitfähigen Schichten an eine oder beide Seiten des isolierenden Substrats gekoppelt sind, wobei die leitfähigen Schichten auf der gleichen Seite des isolierenden Substrats elektrisch voneinander getrennt sind, wobei zumindest eine leitfähige Schicht (16) die Funktion einer Abschirmung und/oder Ablenkung der durch den stromführenden Leiter erzeugten Feldlinien des elektrischen Felds hat, und wobei das isolierende Substrat ebenfalls die Funktion einer mechanischen Halterung für das Mehrschichtelement hat,
**dadurch gekennzeichnet, dass**
der elektrische Leiter und das mehrschichtige Element gemeinsam mit dem elektrisch isolierenden Material des Vorrichtungskörpers geformt werden.

10. Vorrichtung nach dem vorstehenden Anspruch, aufweisend einen teilweise in den Körper aus isolierendem Material eingebetteten elektrischen Anschluss für die elektrische Verbindung mit dem mehrschichtigen Element.

11. Vorrichtung nach Anspruch 9 oder 10, wobei das elektrisch isolierende Material ausgewählt ist aus Epoxidharz, LSR, SSR, HCR, EPDM, XLPE, PSU, PEEK.

12. Verfahren nach einem der Ansprüche 1 bis 8, wobei das mehrschichtige Element einen Thermoform- und/oder Elektroschweiß- und/oder Fotogravur-Prozess durchläuft, bevor es in der Form platziert wird.

## Revendications

1. Procédé de détection et/ou de mesure de quantités physiques associées à un conducteur électrique (2) sous tension au moins partiellement intégré ou inséré dans un corps de dispositif fait d'un matériau isolant, comprenant les étapes consistant à :
- fournir un élément multicouche (10) ;
- donner à l'élément multicouche une forme cylindrique ou tronconique ;
dans lequel l'élément multicouche comprend au moins un substrat isolant (12) fait d'un treillis de fibres minérales, par exemple une fibre de verre, incrusté dans une matrice de matériau isolant, de préférence à base d'époxy, et une pluralité de couches conductrices (14, 16) couplées audit au moins un substrat isolant et comprenant des capteurs et/ou des transducteurs et/ou des réseaux de circuits pour remplir une ou plusieurs fonctions comprenant la détection, la mesure, la protection, la commutation, la modulation, la gestion et/ou la communication de signaux acquis, lesdites couches conductrices étant couplées sur une ou deux faces du substrat isolant, les couches conductrices couplées à la même face du substrat isolant étant électriquement séparées les unes des autres, dans lequel au moins une couche conductrice (16) a pour fonction d'arrêter et/ou de dévier les lignes de champ du champ électrique généré par le conducteur sous tension, et dans lequel le substrat isolant a également une fonction de support mécanique pour l'élément multicouche,
**caractérisé par** :
le positionnement du conducteur électrique et de l'élément multicouche dans une cavité d'un moule pour la construction du corps de dispositif, l'élément multicouche étant placé de manière coaxiale par rapport au conducteur électrique ; - le co-moulage du conducteur électrique et de l'élément multicouche avec le matériau isolant.

2. Procédé selon la revendication 1, dans lequel l'élément multicouche comprend une pluralité de couches conductrices couplées à l'une ou aux deux faces d'un substrat isolant, les couches conductrices couplées à la même face du substrat isolant étant électriquement séparées les unes des autres.

3. Procédé selon l'une quelconque des revendications précédentes, dans lequel l'élément multicouche comprend au moins deux couches conductrices couplées à des faces opposées du substrat isolant, l'élément multicouche étant traversé par au moins un trou métallisé approprié pour connecter électriquement des couches conductrices couplées à des faces opposées du substrat isolant.

4. Procédé selon l'une quelconque des revendications précédentes, dans lequel, dans au moins une des couches conductrices, sont obtenues par photogravure plusieurs parties conductrices électriquement découplées les unes des autres afin d'obtenir des couplages capacitifs ayant des taux de conversion différents.

5. Procédé selon l'une quelconque des revendications précédentes, dans lequel une ou plusieurs couches conductrices forment une antenne RFID.

6. Procédé selon l'une quelconque des revendications précédentes, dans lequel chaque couche isolante est faite d'un tissu de fibres de verre entrelacé dans une matrice de résine époxy, de préférence ignifuge et auto-extinguible.

7. Procédé selon l'une quelconque des revendications précédentes, dans lequel la forme de l'élément multicouche est obtenue par un procédé de thermoformage et/ou d'électrosoudure et/ou de photogravure.

8. Procédé selon l'une quelconque des revendications précédentes, dans lequel l'élément multicouche présente une épaisseur d'environ 0,2 mm, où chaque couche conductrice présente une épaisseur d'environ 35 µm.

9. Dispositif pour applications électrotechniques dans le domaine des moyennes et hautes tensions, comprenant un corps de dispositif fait d'un matériau électriquement isolant, au moins un conducteur électrique (2) au moins partiellement intégré ou inséré dans le corps de dispositif, et un élément multicouche (10) intégré dans le corps du dispositif autour du conducteur électrique,
dans lequel l'élément multicouche présente une forme cylindrique ou tronconique de manière à être positionné autour du conducteur électrique et comprend au moins un substrat isolant (12) fait d'un treillis de fibres minérales, par exemple une fibre de verre, incrusté dans une matrice de matériau isolant, de préférence à base d'époxy, et une pluralité de couches conductrices (14, 16) couplées audit au moins un substrat isolant et comprenant des capteurs et/ou des transducteurs et/ou des réseaux de circuits pour remplir une ou plusieurs fonctions comprenant la détection, la mesure, la protection, la commutation, la modulation, la gestion et/ou la communication de signaux acquis, lesdites couches conductrices étant couplées sur une ou deux faces du substrat isolant, les couches conductrices couplées à la même face du substrat isolant étant électriquement séparées les unes des autres, dans lequel au moins une couche conductrice (16) a pour fonction d'arrêter et/ou de dévier les lignes de champ du champ électrique généré par le conducteur sous tension, et dans lequel le substrat isolant a également une fonction de support mécanique pour l'élément multicouche,
**caractérisé en ce que** le conducteur électrique et l'élément multicouche sont co-moulés avec le matériau électriquement isolant du corps de dispositif.

10. Dispositif selon la revendication précédente, comprenant un connecteur électrique partiellement incrusté dans le corps fait d'un matériau isolant pour la connexion électrique à l'élément multicouche.

11. Dispositif selon la revendication 9 ou 10, dans lequel le matériau électriquement isolant est sélectionné parmi une résine époxy, LSR, SSR, HCR, EPDM, XLPE, PSU, PEEK.

12. Procédé selon l'une quelconque des revendications 1 à 8, dans lequel l'élément multicouche subit un procédé de thermoformage et/ou d'électrosoudure et/ou de photogravure avant d'être placé dans le moule.
